# EUROPÄISCHE PATENTANMELDUNG

(11) **EP 2 431 754 A2**
(43) Veröffentlichungstag der Anmeldung: **21.03.2012**
(21) Anmeldenummer: 11181501.5
(22) Anmeldetag: 15.09.2011
(51) Int. Cl.: G01R 31/40

(54) **Verfahren zur Bestimmung einer räumlichen Anordnung von Photovoltaikmodulgruppen einer Photovoltaikanlage**

(30) Priorität: 16.09.2010 DE 102010037582
(71) Anmelder: SMA Solar Technology AG, 34266 Niestetal (DE)
(72) Erfinder: Magnussen, Björn, 3413 Kassel (DE); Klein, Jens, 37075 Göttingen (DE); Gunkel, Tobias, 34466 Wolfhagen (DE)
(74) Vertreter: Kleine, Hubertus

(57) **Zusammenfassung**

Das Verfahren zur Bestimmung einer räumlichen Anordnung von Photovoltaikmodulgruppen (10) einer Photovoltaikanlage (1) weist die folgenden Schritte auf: Eine Folge von Messwerten einer bestrahlungsabhängigen elektrischen Kenngröße von unterschiedlichen Photovoltaikmodulgruppen (10) wird gemessen, während die Photovoltaikanlage (1) einer Lichteinstrahlung mit einer zeitlich und räumlich variierenden Einstrahlungsintensität ausgesetzt wird. Es wird die relative räumliche Anordnung der Photovoltaikmodulgruppen (10) zueinander durch Vergleichen von unterschiedlichen Photovoltaikmodulgruppen zugeordneten Folgen von Messwerten bestimmt.

## Beschreibung

Die Erfindung betrifft ein Verfahren zur Bestimmung einer räumlichen Anordnung von Photovoltaikmodulgruppen einer Photovoltaikanlage, insbesondere einer Photovoltaikanlage mit einer Vielzahl von Photovoltaikmodulgruppen. Die Erfindung betrifft weiterhin eine Photovoltaikanlage mit einer Einrichtung zur Bestimmung einer räumlichen Anordnung von Photovoltaikmodulgruppen.

Photovoltaikanlagen, insbesondere Freilandanlagen, können eine große Anzahl von Photovoltaikmodulen aufweisen, von denen jeweils mehrere, meist benachbarte, zu Photovoltaikmodulgruppen zusammengefasst sind. Typisch ist zum Beispiel eine Reihenverschaltung der Module einer Gruppe zu einem sogenannten String.

Jeder Gruppe innerhalb der Anlage kann ein eigener Wechselrichter zur Umwandlung des erzeugten Gleichstroms in Wechselstrom zur Einspeisung in ein Versorgungsnetz zugeordnet sein. Alternativ können mehrere Gruppen zusammen mit einem Wechselrichter verbunden sein, der für eine entsprechend höhere Leistung ausgelegt ist. In einem solchen Fall kann der Wechselrichter einen Wechselspannungsschaltkreis, jedoch gleichspannungsseitig mehrere Eingangsschaltkreise zur Verbindung mit den einzelnen Gruppen aufweisen.

Bei der Planung einer größeren Freilandanlage wird üblicherweise versucht, eine gewisse Regelmäßigkeit in der geometrischen Anordnung der einzelnen Module und Strings und ihrer Zuordnung zu den innerhalb der Freilandanlage verteilt aufgestellten Wechselrichtern einzuhalten. Der Grundriss einer Freilandanlage folgt jedoch meist nicht der Form einer einfachen geometrischen Figur, wie z. B. einem Rechteck. Gerade im Randbereich einer Freilandanlage, oder auch bei nachträglich ausgeführten Erweiterungen oder Reparaturen wird die Regelmäßigkeit jedoch häufig durchbrochen. Im Resultat ist bei vielen größeren Anlagen die genaue Position einzelner Gruppen von Modulen, die einem bestimmten Wechselrichter oder Wechselrichterkreis zugeordnet sind, nicht bekannt.

Ein Fehlerfall, zum Beispiel eine ausgefallene oder in seiner Leistung abgefallene String wird durch in den Wechselrichtern üblicherweise vorhandene Überwachungseinrichtungen meist erkannt und über ein Datennetz einer Zentrale auch gemeldet. Dabei wird meist eine Seriennummer des Wechselrichters ausgegeben, die jedoch nichts darüber aussagt, wo der Wechselrichter eingebaut ist. In einem Anlagenplan ist die Seriennummer häufig ebenfalls nicht verzeichnet, da sie bei der Erstellung des Anlagenplans während der Anlagenplanung noch nicht bekannt ist. Schon die Lokalisierung eines Wechselrichters ist daher oft aufwändig. Eine Behebung des Fehlers innerhalb eines Strings oder seiner Verkabelung erfordert zusätzlich die Lokalisierung des Strings, was ohne einen Zuordnungsplan jedoch nur über ein mühsames Nachverfolgen der Verkabelung zwischen einem Wechselrichter und den angeschlossenen Elementen möglich ist. Auch dieses Nachverfolgen ist aufwändig und fehlerträchtig.

Es ist daher eine Aufgabe der vorliegenden Erfindung, ein zuverlässiges Verfahren zur Bestimmung der räumlichen Anordnung von Photovoltaikmodulgruppen einer Photovoltaikanlage bereitzustellen.

Diese Aufgabe wird durch ein Verfahren mit den im Anspruch 1 angegebenen Merkmalen gelöst. Diese Aufgabe wird weiterhin durch eine Photovoltaikanlage mit einer Einrichtung zur Bestimmung der räumlichen Anordnung von Photovoltaikmodulgruppen gemäß Anspruch 21 gelöst.

Gemäß einem Aspekt weist das Verfahren zur Bestimmung einer räumlichen Anordnung von Photovoltaikmodulgruppen einer Photovoltaikanlage die folgenden Schritte auf. Eine Folge von Messwerten einer bestrahlungsabhängigen elektrischen Kenngröße von unterschiedlichen Photovoltaikmodulgruppen wird gemessen, während die Photovoltaikanlage einer Lichteinstrahlung mit einer zeitlich und räumlich variierenden Einstrahlungsintensität ausgesetzt wird. Es wird die relative räumliche Anordnung der Photovoltaikmodulgruppen zueinander durch Vergleichen von unterschiedlichen Photovoltaikmodulgruppen zugeordneten Folgen von Messwerten bestimmt.

Erfindungsgemäß werden Messwerte einer bestrahlungsabhängigen elektrischen Kenngröße, zum Beispiel aus Strom-, Spannungs- oder Leistungsmessungen an den Photovoltaikmodulgruppen, zur Bestimmung der räumlichen Anordnung der Photovoltaikmodulgruppen zueinander eingesetzt. Damit kann aus Messwerten, die beim Betrieb der Anlage sowieso anfallen und üblicherweise auch erfasst werden, ein Anlagentopologieplan erstellt werden. In einer vorteilhaften Ausgestaltung des Verfahrens umfasst das Vergleichen ein Ermitteln einer Ähnlichkeit eines Zeitverlaufs der Folgen von Messwerten. Verschattungsereignisse, z.B. hervorgerufen durch einen Vorbeizug von Wolken, führen zu einem charakteristischen Zeitverlauf einer Messwertfolge. Der Grad der Ähnlichkeit ist dabei üblicherweise mit der räumlichen Anordnung der Photovoltaikmodulgruppen korreliert. Der Grad der Ähnlichkeit ist beispielsweise in der Regel umso größer, je näher die

Photovoltaikmodulgruppen zusammen liegen.

In einer weiteren vorteilhaften Ausgestaltung des Verfahrens umfasst das Vergleichen ein Ermitteln von Zeitverschiebungen zwischen den Folgen von Messwerten. Auf diese Weise können die Folgen der Messwerte zueinander auf einfache Weise in Beziehung gesetzt werden. Im Hinblick auf eine Verarbeitung der Messwerte wird eine vorteilhafte Datenreduktion erreicht.

In einer weiteren vorteilhaften Ausgestaltung des Verfahrens wird die zeitlich und räumlich variierende Einstrahlungsintensität durch eine manuell induzierte Verschattung hervorgerufen. In einer weiteren vorteilhaften Ausgestaltung des Verfahrens wird die räumlich variierende Einstrahlungsintensität durch eine Verschattung durch Wolken hervorgerufen.

Weitere vorteilhafte Ausgestaltungen und Weiterbildungen der Erfindung sind in den abhängigen Ansprüchen angegeben.

Im Folgenden wird die Erfindung anhand von Ausführungsbeispielen mithilfe von vier Figuren näher erläutert.

Die Figuren zeigen:
- Fig. 1: eine schematische Aufsicht auf eine Photovoltaikanlage;
- Fig. 2: ein Flussdiagramm eines Verfahrens zur Bestimmung der räumlichen Anordnung von Photovoltaikmodulgruppen;
- Fig.3: ein Beispiel zeitabhängiger Messwerte des Stroms zweier Photovoltaikmodulgruppen; und
- Fig. 4: schematische Darstellungen einer Photovoltaikanlage und ermittelter Verschattungszeitpunkte zur Illustration einer weiteren Ausgestaltung des Verfahrens.

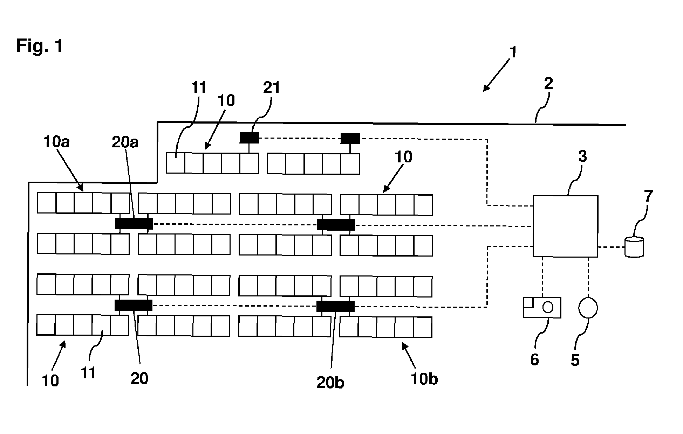

Figur 1 zeigt einen Ausschnitt einer Photovoltaikanlage 1 in einer schematischen Aufsicht. Die Photovoltaikanlage 1 weist eine Vielzahl von Photovoltaikmodulgruppen 10 auf, von denen jede wiederum eine Mehrzahl von Photovoltaikmodulen 11 umfasst. Die Photovoltaikmodule 11 jeder Gruppe 10 sind elektrisch miteinander verbunden, zum Beispiel serienverschaltet als sogenannte Strings. Im Weiteren wird die Bezeichnung "Photovoltaik" als "PV" abgekürzt.

Die gezeigte Anordnung stellt beispielsweise einen kleineren Ausschnitt einer Freiland- oder Feldanlage dar, die mehrere hundert bis hin zu mehreren tausend PV-Modulgruppen 10 umfassen kann. Die geometrische Begrenzung der PV-Anlage 1 ist im Bereich der dargestellten PV-Modulgruppen 10 durch eine Umrandung 2 skizziert.

Die einzelnen PV-Modulgruppen 10 sind elektrisch mit im Anlagenbereich verteilt aufgestellten Wechselrichtern 20, 21 verbunden. Eine wechselstromseitige Verkabelung zur Einspeisung des von den PV-Modulgruppen 10 erzeugten und von den Wechselrichtern 20, 21 umgewandelten Stroms in ein Stromnetz ist ebenfalls aus Gründen der Übersichtlichkeit nicht dargestellt.

Es kommen, wie häufig in größeren Anlagen, im gezeigten Ausführungsbeispiel unterschiedliche Wechselrichter zum Einsatz. Beispielhaft sind Mehrkreiswechselrichter 20 dargestellt, die mit je vier PV-Modulgruppen 10 verbunden sind, und Einzelwechselrichter 21, die der Umwandlung des von jeweils einem Photovoltaik-Element 10 gelieferten Stroms dienen. Der Übersichtlichkeit halber sind nicht alle PV-Modulgruppen, PV-Module und Wechselrichter mit Bezugszeichen versehen.

Es wird darauf hingewiesen, dass die Erfindung jedoch nicht nur im Zusammenhang mit Freilandanlagen eingesetzt werden kann, sondern sich auch für kleinere PV-Anlagen, beispielsweise Dachanlagen, eignet. Auch bei PV-Anlagen die ganz oder teilweise mit sogenannten Modulwechselrichtern ausgestattet sind, kann das erfindungsgemäße Verfahren eingesetzt werden. Wenn im Rahmen dieser Anmeldung auf PV-Modulgruppen Bezug genommen wird, sollen damit auch solche Gruppen umfasst sein, die nur von einem einzelnen PV-Modul gebildet sind.

Die PV-Anlage 1 umfasst weiterhin eine Einrichtung 3 zur Bestimmung der räumlichen Anordnung der PV-Modulgruppen 10. Die Einrichtung 3 ist über Signalleitungen 4 mit den Wechselrichtern 20, 21 verbunden. Über die Signalleitungen 4 übertragen die Wechselrichter 20, 21 Messwerte von bestrahlungsabhängigen elektrischen Kenngrößen der PV-Modulgruppen 10. In diesem Sinne stellt jedes PV-Modul 11 oder jede Verschaltung mehrerer PV-Module 11, deren Kenngröße(n) unabhängig erfasst wird, eine PV-Modulgruppen 10 dar. Die Messwerte werden bevorzugt in digitaler Form übertragen, wobei die Signalleitungen 4 Leitungen eines Datennetzwerkes sein können. Üblicherweise werden Informationen über Kenngrößen der PV-Modulgruppen 10 und der Wechselrichter 20, 21 selbst von diesen über Netzwerkanschlüsse bereitgestellt und innerhalb der PV-Anlage 1 zentral erfasst. Vorteilhafterweise ist die Einrichtung 3 daher an diese zentrale Erfassung von Informationen der Wechselrichter 20, 21 angebunden oder mit ihr integriert ausgeführt. Die Einrichtung 3 ist jedoch nicht notwendigerweise ein fester Teil der Photovoltaikanlage 1. Alternativ kann die Einrichtung 3 auch entfernt von der Photovoltaikanlage 1 angeordnet sein oder als mobiles Gerät ausgestaltet sein. Das mobile Gerät, beispielsweise eine Speicherkarte, kann hierzu zur Datenerfassung mit dem Wechselrichter 20, 21 verbunden sein, und später zum Auslesen der Daten mit der Einrichtung 3 gekoppelt werden, was durch den Begriff der Signalleitungen 4 mit umfasst sein soll.

Die PV-Anlage 1 kann zudem in der Fig. 1 nicht dargestellte Einstrahlungssensoren umfassen, die im Anlagenbereich angeordnet sind. Wie die PV-Modulgruppen 10 weisen die Einstrahlungssensoren bestrahlungsabhängige elektrische Kenngrößen auf. Wenn diese erfasst und an die Einrichtung 3 übertragen werden, können die Einstrahlungssensoren im Sinne des erfindungsgemäßen Verfahrens wie PV-Modulgruppen 10 behandelt werden und im Rahmen dieser Anmeldung als solche angesehen werden. Weiterhin ist die Einrichtung 3 optional mit einer Wetterstation 5, einer Kamera 6 und einer Datenbank 7 verbunden. Die Datenbank 7 wird dabei nicht zwingend lokal in der PV-Anlage 1 vorgehalten, sondern es kann sich dabei um eine über ein Datenfernübertragungsnetzwerk, zum Beispiel das Internet, erreichbare Datenbank oder sonstige Informationsquelle handeln.

Die Wechselrichter 20, 21 erfassen im Betrieb laufend elektrische Kenngrößen der an sie angeschlossenen PV-Modulgruppen 10. Die Mehrkreiswechselrichter 20, an die vorliegend jeweils vier PV-Modulgruppen 10 angeschlossen sind, sind dabei in der Lage, die elektrischen Kenngrößen der einzelnen an sie angeschlossenen PV-Modulgruppen 10 getrennt zu erfassen. Alternativ oder zusätzlich ist es auch möglich, Sensoreinrichtungen unabhängig von den Wechselrichtern 20, 21 zur Bestimmung dieser elektrischen Kenngrößen innerhalb der PV-Anlage 1 vorzusehen, die einzelnen PV-Modulgruppen 10 zugeordnet sind. Da die Wechselrichter 20, 21 wie angegeben üblicherweise aber bereits über Messeinrichtungen zur Ermittlung der elektrischen Kenngrößen verfügen, bietet es sich an, auf diese Messeinrichtung zurückzugreifen.

Relevante elektrische Kenngrößen sind beispielsweise der von den PV-Modulgruppen 10 gelieferte Strom I oder die gelieferte Leistung P. Typischerweise werden diese Kenngrößen von den Wechselrichtern 20,21 in etwa im Sekundentakt erfasst und können theoretisch auch in dieser Messfrequenz an die Einrichtung 3 übertragen werden. Dies führt bei einer großen PV-Anlage 1 zu einer sehr großen Datenrate an der Einrichtung 3, so dass gegebenenfalls der Wunsch besteht, das Datenaufkommen zu reduzieren. Hierzu ist es beispielsweise möglich, in den Wechselrichter 20, 21 oder in den Sensoreinrichtungen Schwellenwerte für die Kenngrößen zu definieren, zum Beispiel einen bestimmten Stromschwellenwert Iₛ oder einen bestimmten Leistungsschwellenwert Pₛ, eine relative Änderungsschwelle oder ein an die jeweilige Situation (z. B. Wettersituation) angepasstes Schwellwertkriterium für diese Kenngrößen. Bei Über- oder Unterschreiten dieses Schwellenwertes wird ein entsprechendes Signal, das beispielsweise den Zeitpunkt der Über- oder Unterschreitung enthält, an die Einrichtung 3 zu übertragen. Auf diese Weise werden die Zeitpunkte des Einsetzens und Wiederaufhebens einer Verschattung ermittelt und übertragen und der nachfolgenden Auswertung zugrunde gelegt. Dabei ist es möglich, die Schwellenwerte variabel zu gestalten, z. B. derart, dass sie immer einen festgelegten Bruchteil eines Maximalwertes, beispielsweise eines Tageshöchstwertes, betragen. An dieser Stelle sei darauf verwiesen, dass in der weiteren Beschreibung der Begriff der Verschattung auch den Fall der Entschattung äquivalent mit abdecken soll.

Neben den gemessenen Strom- oder Leistungswerten I, P können alternativ auch deren Änderungsraten (zeitliche Ableitungen, z. B. erste und/oder zweite zeitliche Ableitungen) betrachtet werden. Auch dabei können Schwellwerte für die Änderungsraten der elektrischen Kenngröße zur Bestimmung von Verschattungszeitpunkten (bzw. von Zeitpunkten, an denen die Verschattung wieder aufgehoben wird) verwendet werden. Weiter kann vorgesehen sein, die Verschattungszeitpunkte anhand von Maxima in der Änderungsrate zu ermitteln.

Um möglichst eindeutige Signale zu generieren, kann optional auch zusätzlich verlangt werden, dass nur solche Signale weitergeleitet werden, bei denen in einem geeigneten Zeitraum davor und danach kein weiteres Signal detektiert wurde.

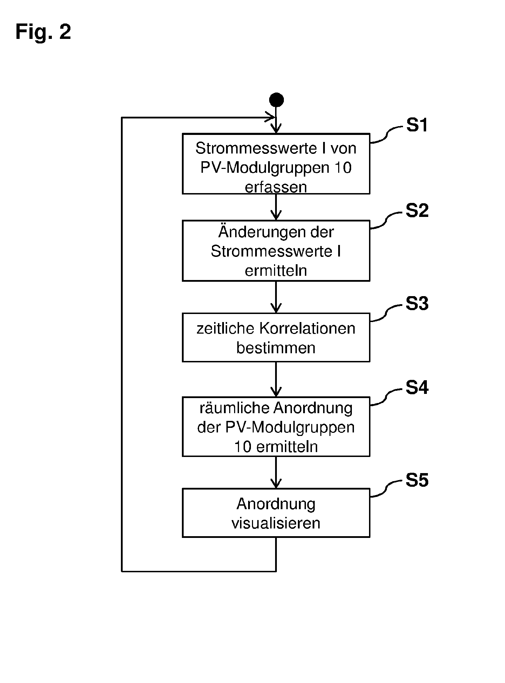

Die Grundidee des Verfahrens zur Bestimmung der räumlichen Anordnung der PV-Modulgruppen 10, das beispielsweise von der in Fig. 1 dargestellten PV-Anlage 1 und insbesondere der Einrichtung 3 durchgeführt werden kann, ist im Flussdiagramm der Figur 2 wiedergegeben.

In einem ersten Schritt S1 wird eine Folge von Messwerten einer elektrischen Kenngröße, beispielsweise des Stroms I, für PV-Modulgruppen 10 einer PV-Anlage 1 erfasst. In einem optionalen zweiten Schritt S2 werden Änderungszeitpunkte der Messwertfolgen (wie Verschattungszeitpunkte) ermittelt, zum Beispiel durch Vergleich mit einem vordefinierten Schwellenwert.

In einem dritten Schritt S3 werden zeitliche Verschiebungen zwischen Folgen von Messwerten die unterschiedlichen PV-Modulgruppen 10 zugeordnet sind, bestimmt. Diese zeitliche Verschiebungen geben an, mit welchen Zeitdifferenzen Messwertfolgen, die an unterschiedlichen PV-Modulgruppen 10 erfasst werden, ähnliche Verläufe aufweisen, oder, anders ausgedrückt, wie Messwertfolgen zeitlich miteinander korreliert sind.

Die Bestimmung der zeitlichen Verschiebungen kann im Falle des optionalen Schrittes S2 durch Differenzbildung zwischen den Änderungszeitpunkten unterschiedlicher PV-Modulgruppen 10 erfolgen. Alternativ ist es aber beispielsweise auch möglich, die zeitliche Verschiebung durch eine mathematische Korrelationsfunktion zwischen Messwertfolgen unterschiedlicher Modulgruppen zu bestimmen, so dass die Zuweisung eines konkreten Änderungszeitpunktes zu einer einzelnen Messwertfolge nicht notwendig ist, um eine zeitliche Verschiebung eines Verschattungsereignisses zwischen PV-Modulgruppen 10 zu ermitteln.

In einem vierten Schritt S4 wird anhand dieser Zeitverschiebungen die relative räumliche Anordnung der PV-Modulgruppen 10 zueinander ermittelt. Räumlich ist in diesem Zusammenhang als geometrisch zu verstehen und beinhaltet keine Aussage über die Anzahl der Dimensionen. Bevorzugt betrifft das Verfahren jedoch die Bestimmung einer 2-dimensionalen Anordnung. In einem optionalen fünften Schritt S5 wird die bestimmte Anordnung visualisiert, zum Beispiel in Form eines topologischen Anlagenplans. Anschließend kann das Verfahren wieder mit dem ersten Schritt S1 erneut durchgeführt werden, wobei die in dem oder den zuvor erfolgten Durchläufen gewonnenen Ergebnisse berücksichtigt werden. Auf diese Weise verbessert sich die Genauigkeit des Ergebnisses iterativ. Die Genauigkeit des Ergebnisses betrifft die Größe der Unsicherheit, mit der die ermittelten Positionen der PV-Modulgruppen 10 behaftet sind.

Im Folgenden sind Ausgestaltungen des Verfahrens detaillierter beschrieben.

In einer ersten Ausgestaltung des Verfahrens wird die zeitlich und räumlich variierende Einstrahlungsintensität durch eine manuell induzierte Verschattung hervorgerufen. Dazu kann beispielsweise eine verschattende Fahne sukzessive über einzelne PV-Modulgruppen 10 der PV-Anlage 1 gezogen werden, wobei gleichzeitig die geografische Position des Fahnenträgers aufgezeichnet wird. Dazu kann ein sogenannter GPS (Global Positioning System)-Rekorder (Tracker) verwendet werden. Während dieses manuell induzierten Verschattungsvorgangs zeichnet die Einrichtung 3 Messwerte der elektrischen Kenngrößen der PV-Modulgruppen 10 auf. Dieses können, wie weiter oben ausgeführt, die Messgrößen selbst sein oder auch Zeitwerte, zu den bestimmte vorgegebene Schwellwerte über- oder unterschritten werden. Beispielsweise können Schwellwerte so eingestellt sein, dass sie bei durchschnittlicher Tagesbeleuchtung überschritten werden, bei Verschattung eines der Module 11 eines PV-Modulgruppen 10 jedoch unterschritten werden. Von der Einrichtung 3 wird somit erfasst, wann welche PV-Modulgruppe 10 von der manuell induzierten Verschattung betroffen war. Ein danach vorgenommener Abgleich mit den Positionsinformationen des GPS-Trackers ermöglicht, den einzelnen PV-Modulgruppen 10 eine geographische Position zu zuordnen. Anhand dieser Informationen kann ein Anlagenplan, ein schematisches topologisches Abbild der Anordnung der einzelnen PV-Modulgruppen 10, der PV-Anlage 1 erstellt werden.

In einer weiteren Ausgestaltung des Verfahrens wird die Verschattung der PV-Modulgruppen 10 nicht manuell induziert, sondern es werden natürlich auftretende Verschattungsphänomene, die zu einer zeitlich und räumlich variierenden Einstrahlungsintensität führen, ausgenutzt. Eine natürliche Verschattung, die zu einer derart variierenden Einstrahlungsintensität führt, ist durch vorbeiziehende Wolken gegeben. Eine weitere natürliche (Teil-) Verschattung kann durch einen Schattenwurf von Elementen in der Nähe der PV-Modulgruppen erfolgen. Solche Elemente können Bäume, Türme oder Gebäudeteile, z.B. Schornsteine, oder ähnliches sein. Solche Elemente können aber auch Teil der PV-Anlage selbst sein, z.B. benachbarte PV-Modulgruppen oder auch Teile der betrachteten PV-Modulgruppe selbst.

Gerade bei der Anwendung des Verfahrens auf kleinere PV-Anlagen wie Dachanlagen ist die Nutzung der natürlichen Verschattung, beispielsweise durch Bäume oder Teile der Dachkonstruktion, besonders vorteilhaft, da sich durch die räumliche Nähe der PV-Modulgruppen untereinander eine einfach auszuwertende, sich im Wesentlichen täglich wiederholende Variation der Einstrahlungsintensität ergibt. Alternativ oder zusätzlich kann durch Messung der bestrahlungsabhängigen elektrischen Kenngröße mit einer Zeitauflösung von einer Sekunde oder weniger, z.B. von 0,1 s, das Verfahren auch für solche PV-Kleinanlagen erfolgreich eingesetzt werden.

Im Folgenden wird ein Verfahren, bei dem eine Verschattung durch Wolken ausgewertet wird, wiederum mit Referenz auf die PV-Anlage 1 der Fig. 1 beschrieben.

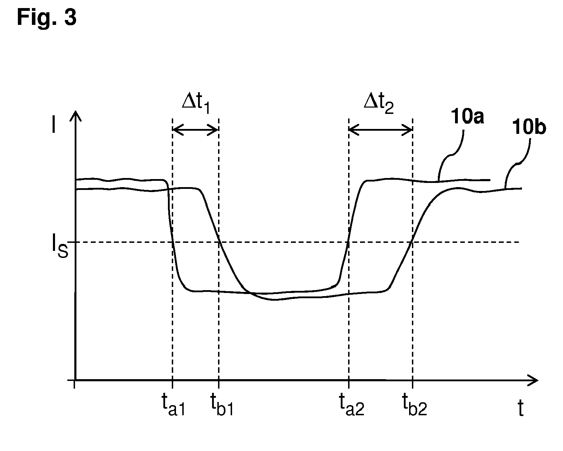

Figur 3 zeigt beispielhaft den Verlauf des Stroms I als eine beleuchtungsabhängige elektrische Kenngröße von zwei PV-Modulgruppen 10, zum Beispiel den in Figur 1 ausgewiesenen Gruppen 10a und 10b, als Funktion der Zeit t. Die gestrichelte horizontale Linie gibt einen vorgegeben Stromschwellenwert Iₛ an, bei dessen Unter- oder Überschreiten eine Nachricht vom Wechselrichter 20a oder 20b, mit dem die entsprechende Gruppe 10a, 10b zugeordnet ist, an die Einrichtung 3 weitergegeben wird. Der Schwellwert kann als vorgegebener Festwert, als relativer Bezugswert oder dynamisch unter Berücksichtigung der aktuell vorherrschenden Bedingungen (z. B. der Wetterbedingungen) bestimmt werden,

Die Fig. 3 gibt den zeitabhängigen Stromverlauf für eine Situation wieder, bei der eine Wolke von links nach rechts (bezogen auf Fig. 1) über die PV-Anlage 1 hinweg zieht. Wie zu erkennen ist, erreicht die mit einer in Zugrichtung vorderen Wolkengrenze verbundene Verschattung zunächst die PV-Modulgruppe 10a, deren gelieferter Strom daraufhin unter den eingetragenen Stromschwellenwert Iₛ absinkt. Als Folge sendet der Mehrkreiswechselrichter 20a eine diesbezügliche Nachricht an die Einrichtung 3, wobei die Nachricht neben einer Kennzeichnung der PV-Modulgruppe 10a den Zeitpunkt des Unterschreitens des Schwellenwerts, in der Fig. 3 als tₐ₁ bezeichnet, umfasst. Zu einem Zeitpunkt t_{b1} geschieht gleiches für die PV-Modulgruppe 10b, was der Einrichtung 3 vom Mehrkreiswechselrichter 20b mitgeteilt wird.

Zu den Zeitpunkten tₐ₂ und t_{b2} wird umgekehrt die Verschattung der PV-Modulgruppen 10a, 10b nach Vorbeiziehen des Schattens der hinteren Front der Wolke wiederaufgehoben. Wie in Fig. 3 ersichtlich, ist die Zeitdifferenz Δt₁= t_{b1} - tₐ₁ und Δ t₂= t_{b2} - tₐ₂ vorliegend nicht gleich. Dieses kann zum einen seinen Grund darin haben, dass die vordere Front der Wolke anders ausgerichtet ist als die hintere Front der Wolke, oder darin, dass die Wolke ihre Geschwindigkeit während ihrer Bewegung über die PV-Anlage 1 verändert hat.

Selbst wenn Parameter einer einzelnen Wolke, wie ihre Zugrichtung, ihre Zuggeschwindigkeit und die Form bzw. Ausrichtung der vorderen und hinteren Fronten nicht bekannt sind, können aus den gewonnenen Messwerten Informationen über die Anordnung der PV-Modulgruppen 10 innerhalb der PV-Anlage 1 gewonnen werden, zum Beispiel durch statistische Mittelung über eine Vielzahl von Verschattungsereignissen. Beispielsweise tritt unabhängig von diesen Parametern regelmäßig der Fall ein, dass am Rand, also zum Beispiel benachbart zur Umrandung 2 in Fig. 1 liegende PV-Modulgruppen jeweils vor weiter in der Mitte liegenden Gruppen eine Verschattung erfahren.

Weiterhin ist, da Wolkenfronten in den wenigsten Fällen genau parallel zu einer Seitenkante der PV-Anlage 1 ausgerichtet sind, die Wahrscheinlichkeit hoch, dass an Ecken liegende PV-Modulgruppen, zum Beispiel die Gruppe 10a im Ausführungsbeispiel der Figur 1, noch vor anderen am Rand liegenden PV-Modulgruppen 10 von einer Verschattung betroffen sind. Darüber hinaus kann in guter Näherung häufig davon ausgegangen werden, dass innerhalb eines bestimmten Zeitraums, zum Beispiel eines Tages, die Windrichtung sich nicht, oder nur wenig ändert. Alle im Laufe dieses Zeitraums gesammelten Informationen können somit beispielsweise genutzt werden, um an den Ecken und an den Rändern liegende PV-Modulgruppen 10 zu identifizieren und - natürlich zunächst nur im Bezug auf die Zugrichtung der Wolken - relativ zueinander vorläufig in einem Abbild der PV-Anlage 1 zu positionieren. An den Rändern einer PV-Anlage liegende PV-Modulgruppen zeichnen sich zudem dadurch aus, dass sie typischerweise in den Morgen- oder Abendstunden eine geringere Verschattung durch benachbarte PV-Modulgruppen erfahren als weiter im Inneren liegende PV-Modulgruppen. Auch dieses kann zu ihrer Identifizierung eingesetzt werden.

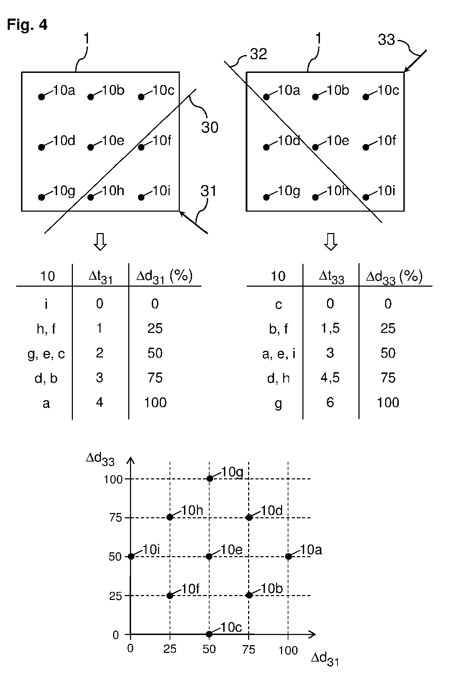

Figur 4 zeigt in 5 Teilbildern a) bis e) beispielhaft, wie durch eine Auswertung von bereits zwei unterschiedlichen Verschattungsereignissen beim Überqueren von Wolkenfronten ein erster angenäherter Plan der Anlagentopologie erstellt werden kann. Der Auswertung liegen zwei Verschattungsereignisse zugrunde, bei denen jeweils eine einzelne, jedoch bei den beiden Ereignissen unterschiedliche PV-Modulgruppe zuerst eine Verschattung erfährt.

In den Figuren 4a, 4b ist beispielhaft eine PV-Anlage 1 zu zwei verschiedenen Zeitpunkten gezeigt, die neun PV-Modulgruppen 10 a bis 10 i umfasst, die in einem regelmäßigen Muster in drei Zeilen und drei Spalten angeordnet sind. Für jede der PV-Modulgruppen 10 kann separat ein Verschattungszeitpunkt erfasst werden.

Die PV-Anlage 1 wird in Figur 4a beispielhaft von einer ersten Schattenfront 30 einer Wolke überquert, die sich mit einer bestimmen Geschwindigkeit in einer ersten Richtung 31 bewegt. Zum dargestellten Zeitpunkt hat die Schattenfront 30 soeben die PV-Modulgruppen 10 h und 10 f erreicht. In Figur 4b ist die PV-Anlage 1 zu einem anderen Zeitpunkt dargestellt, zu dem eine zweite Schattenfront 32 die PV-Anlage 1 in einer zweiten Richtung 33 überquert und soeben die PV-Modulgruppen 10 a, e, i verschattet hat.

In Fig. 4c, 4d ist in jeweils einer Tabelle für die beiden im oberen Teil dargestellten Verschattungsereignisse aufgelistet, in welcher zeitlichen Reihenfolge Δt (mittlere Spalte) die einzelnen PV-Modulgruppen 10 (linke Spalte) durch die entsprechende Schattenfront 30, 32 eine Verschattung erfahren. In der rechten Spalte der Tabellen ist jeweils der zeitliche Abstand Δt auf eine Position Δd relativ zur Ausdehnung der PV-Anlage 1 in der entsprechenden Richtung 31 bzw. 33 der Bewegung der Schattenfronten 30 bzw. 32 übertragen. Dazu wird der größte zeitliche Abstand gleich einer Position Δd=100% gesetzt.

In Fig. 4e sind die aufgefundenen Abstände paarweise für jede PV-Modulgruppe 10 in ein Koordinatensystem eingetragen. Beispielsweise ist die Position der PV-Modulgruppe 10h mit den aufgefundenen relativen Positionen (25, 75) als Koordinaten eingetragen. Auf diese Weise kann aus den Verschattungszeitpunkten eine erste vorläufige Positionskarte erstellt werden, in der die Anlagentopologie projiziert auf die zugrundeliegenden Richtungen 31, 33 wiedergegeben ist.

Die Normierung auf einen Wertebereich von 0 bis 100% für die relativen Positionen macht das Verfahren unabhängig von der Geschwindigkeit, mit der die Schattenfronten 30, 32 über die PV-Anlage 1 hinweg ziehen. Im Resultat sind ermittelte Abstandsangaben damit natürlich ebenfalls nur relative und keine absolute Angaben. Da die absoluten Ausmaße einer PV-Anlage 1 aber üblicherweise bekannt sind, können die aufgefundenen relativen Abstände entsprechend skaliert werden.

Zur einfacheren Darstellung wurden in dem Beispiel Schattenfronten 30 und 32 gewählt, die im Wesentlichen diagonal zur regelmäßigen Ausrichtung der PV-Modulgruppen 10 verlaufen. Aus diesem Grund erfahren auf den Diagonalen liegende PV-Modulgruppen 10 im dargestellten Beispiel gleichzeitig eine Verschattung. Auch sind die Schattenfronten 30 und 32 zueinander diagonal ausgerichtet. Das Verfahren lässt sich jedoch ebenso mit beliebig ausgerichteten Schattenfront durchführen, wobei der resultierende Anlagentopologieplan dann entsprechend wie ein Parallelogramm verzerrt wäre.

Ein solcher vorläufiger Anlagentopologieplan kann nachfolgend unter Einbeziehung weiterer Messwerte von Verschattungszeitpunkten sukzessive verbessert werden, beispielsweise wie im Folgenden beschrieben ist.

Zunächst wird für jede PV-Modulgruppe 10 eine Startposition als aktuelle Positionen der PV-Modulgruppen 10 in einem Anlagentopologieplan bestimmt. Dieses kann entweder aus einem vorgelagerten Verfahren, wie z. B. dem im Zusammenhang mit Fig. 4 beschriebenen, erfolgen oder es können zufällige Startpositionen gewählt werden. Zudem wird für jede Paarung von zwei PV-Modulgruppen 10 ein geometrischer Vorzugsabstand festgelegt, der zunächst auf einen (bevorzugt tendenziell eher zu kleinen) Startwert initialisiert wird. Als Startwert kann beispielsweise die Längen der kleinsten innerhalb der PV-Anlage 1 vorkommenden Ausdehnung einer der PV-Modulgruppen 10 eingesetzt werden.

Für jede von einem Wolkenvorbeizug hervorgerufene Verschattung wird dann für alle Paarungen der Vorzugsabstand gemäß den folgenden Regeln modifiziert. Tritt bei zwei PV-Modulgruppen einer Paarung eine Verschattung in zeitlich kurzem Abstand ein, wird auf einen eher kleinen Abstand zwischen den Gruppen geschlossen. Die Größe des Abstands kann anhand einer als bekannt vorausgesetzten Windgeschwindigkeit abgeschätzt werden. Wenn der so abgeschätzte Abstand kürzer ist als der der Paarung zugeordnete Vorzugsabstand, so wird der Vorzugsabstand geringfügig reduziert. Zeigt sich bei zwei PV-Modulgruppen einer Paarung jedoch ein zeitlich hoher Abstand in der Verschattung, wird auf einen großen Abstand geschlossen. Wenn dieser Abstand größer ist, als der zugeordnete gespeicherte Vorzugsabstand, so wird der Vorzugsabstand auf diesen aktuell bestimmten Abstand vergrößert.

Dabei kann vorgesehen sein, die entsprechenden Korrekturen an den Abständen nicht bei jedem Wolkenvorbeizug vorzunehmen, sondern eine gewisse Anzahl von Abstandsbestimmungen vorzunehmen und nur ausgewählte dieser Abstandsbestimmungen für eine Korrektur der gespeicherten Abstände einzusetzen. Beispielsweise kann aus einer Gruppe von Abstandsbestimmungen nur die jeweils diejenige ausgewählt werden, die zu den drittgrößten Abstandswerten geführt hat. Damit werden zwei Fehlmessungen, die mit großer Wahrscheinlichkeit in Richtung von zu großen Werten tendieren, ignoriert. Dennoch wird für die Abstandskorrektur eine Messung mit tendenziell eher groß bestimmten Abständen benutzt, was geeigneter ist, um die anfänglich zu kurz gewählten Startabstände in Richtung der tatsächlichen Werte nach oben korrigieren zu können.

Schließlich werden die Positionen der PV-Modulgruppen 10 in dem Anlagentopologieplan so variiert, dass ein Qualitätskriterium, welches auf einem Vergleich der gespeicherten Vorzugsabstände mit den sich aus dem Anlagentopologieplan ergebenden beruht, optimiert wird. Das Qualitätskriterium kann beispielsweise durch die Summe (für alle Paarungen) der Differenzen zwischen den Vorzugsabständen und den Anlagentopologieplan-Abständen gebildet sein. Ein solches Qualitätskriterium ist dann im Positionsoptimierungsprozess zu minimieren.

Dabei kann eine Störgröße eingesetzt werden, über den die Position der PV-Modulgruppen in eine zufällige Richtung um eine zufällige Distanz versetzt wird, wobei die Versetzungsdistanz durch eine Maximaldistanz beschränkt ist. Während des Positionsoptimierungsprozesses wird die Größe der Maximaldistanz von einem vorgegebenen Anfangswert schrittweise auf den Wert 0 reduziert. Eine solche Optimierung unter Störgrößeneinfluss ist auch als simulated annealing bekannt und verhindert, dass das Qualitätskriterium in einem lokalen Minimum gefangen wird. Zur Kontrolle kann mit den gleichen Abstandsdaten ein Optimierungsprozess ausgehend von unterschiedlichen Startpositionen durchgeführt werden. Unterschiedliche Endpositionen in unterschiedlichen Durchläufen des Optimierungsprozesses deuten auf eine noch nicht korrekte Umsetzung der Abstände in Positionen hin und legen z. B. die Vergrößerung des Anfangswertes für die Störgröße nahe. Dabei können aus der Statistik bekannte Methode eingesetzt werden, um einzelne Ausreißer, also deutlich von anderen Endpositionen abweichende Endpositionen, zu erkennen von der weiteren Berücksichtigung auszuschließen.

Zur sukzessiven Verbesserung eines Plans der Anlagentopologie kann auch ein Rückprojektionsverfahren eingesetzt werden. Ausgehend von einem vorläufigen Plan kann für einen nächsten Zeitraum, zum Beispiel einen nächsten Tag, umgekehrt aus Messwerten der elektrischen Kenngröße eine wahrscheinliche Zugrichtung und Geschwindigkeit der Wolken extrahiert werden. Unter Benutzung dieser Zugrichtung und Geschwindigkeit können weitere Messungen von Verschattungszeitpunkten benutzt werden, um die Positionen von PV-Modulgruppen 10 nachzujustieren. Auf diese Weise wird ein iteratives Rückprojektionsverfahren geschaffen, das zunächst ganz ohne weitere Informationen aus sich selbst heraus einen zunehmend akkurater werdenden Anlagentopologieplan mit den Positionen der einzelnen PV-Modulgruppen 10 erstellt. Nach und nach können dabei auch die Positionen der weiter im Inneren der PV-Anlage 1 liegenden PV-Modulgruppen 10 analog ermittelt werden.

Bei bekannter Anlagentopologie kann mathematisch eindeutig aus einem bekannten Verschattungsverlauf der Verlauf von elektrischen Kenngrößen bestimmt werden, es besteht in eindeutiger Funktionszusammenhang. Für die umgekehrte Aufgabe, aus einem gemessenen Verlauf von Kenngrößen eine Anlagentopologie abzuleiten, besteht jedoch kein eindeutiger Funktionszusammenhang. Diesem Umstand tragen die zuvor beschriebene Verfahren durch die Positionsoptimierung bzw. die Rückprojektion Rechnung.

Zusätzlich oder alternativ können auch Informationen über die Zugrichtung und -geschwindigkeit der Wolken, die aus anderen Informationsquellen bezogen werden in weiteren Ausgestaltungen des Verfahrens zur Positionsbestimmung mit herangezogen werden. Zum Beispiel kann eine von der in Figur 1 dargestellten Wetterstation 5 bestimmte Windrichtung und -geschwindigkeit als gute Näherung für die Zugrichtung und -geschwindigkeit der Wolken angesehen werden. Weiterhin können Informationen über die Zugrichtung und - geschwindigkeit der Wolken sowie zusätzlich über die Form der Wolkenkanten auch über die mit der Einrichtung 3 verbundene, den Himmel abfotografierende Kamera 6 gewonnen werden. Schließlich ist es auch denkbar, auf extern zur Verfügung gestellte Wetterinformationen zuzugreifen. In der Fig. 1 ist das durch eine Datenbank 7 angedeutet, die zum Beispiel über das Internet abgefragt werden kann.

Bei dem zuvor beschriebenen Rückprojektionsverfahren ist die Festlegung des Zeitraums, innerhalb dessen man von im Wesentlichen gleichbleibenden Windverhältnissen und damit Wolkenzuggeschwindigkeit und -richtung ausgeht, beispielhaft als ein Tag angegeben. Wegen der langen Pause in der Nacht, in der zum einen das Verfahren nicht durchgeführt werden kann und zum anderen die Wahrscheinlichkeit eines Wetterwechsels hoch ist, stellt ein Tag diesbezüglich eine verfahrenstechnisch und meteorologisch sinnvolle Zeiteinheit dar. Insbesondere wenn jedoch zusätzliche Informationen über die Zugrichtung und -geschwindigkeit der Wolken direkt (z. B. über die Kamera 6) oder indirekt über die Windverhältnisse (z. B. über die Wetterstation 5) vorliegen, kann dieser Zeitraum jedoch durchaus auch kürzer gewählt werden.

Neben dem zuvor beschriebenen Verfahren sind auch andere Verfahren einsetzbar, um aus den erhaltenen Messdaten auf die räumliche Anordnung der PV-Modulgruppen 10 zu schließen. Beispielsweise können für sämtliche kombinatorisch mögliche Paarungen zweier PV-Modulgruppen 10 Korrelationsfunktionen gebildet werden. Wenn die durch die Verschattung hervorgerufenen Messwertänderungen unabhängig von der Wolkenzugrichtung und -geschwindigkeit eine hohe Korrelation aufweisen, muss es sich zwangsläufig um nah nebeneinander liegende Elemente handeln. Zeigt die Korrelation dagegen starke Schwankungen, d. h. es treten sowohl sehr hohe Korrelationswerte auf, als auch Situationen, in denen eine Verschattung unkorreliert eintritt, sind die entsprechenden Elemente weit auseinander. Die Schwankung der Korrelation hängt dann mit der Windrichtung bzw. der Ausrichtung der Wolkenfront zusammen. Bewegt sich eine Wolkenfront parallel zur Verbindungslinie zweiter PV-Modulgruppen 10, tritt die Verschattung korreliert ein, auch wenn sich die PV-Modulgruppen 10 weit auseinander befinden. Bewegt sich die Wolkenfront dagegen in der Richtung der Verbindungslinie der beiden PV-Modulgruppen, ist die Verschattung umso unkorrelierter, je weiter die beiden Elemente voneinander entfernt sind. Aus einer solchen Korrelationsbetrachtung kann der Abstand jeweils zweier PV-Modulgruppen 10 jeweils paarweise bestimmt werden, bei Kenntnis der Zuggeschwindigkeit der Wolken auch quantitativ. Über iterative oder algorithmische Verfahren kann eine zu den paarweise bestimmten Abstandswerten konforme Topologie abgeleitet werden.

Auch ist denkbar, Messungen der Größe einer elektrischen Kenngröße während einer Wolkenverschattung auszunutzen. Wolken haben über ihre Ausdehnung kein einheitliches Dicke- bzw. Lichtabsorptionsprofil. Der zeitliche Verlauf der Resthelligkeit während einer Verschattung gibt das Lichtabsorptionsprofil in einem Streifen der Wolke entlang der Vorbeizugsrichtung wieder. Werden bei zwei PV-Modulgruppen 10 ähnliche Lichtabsorptionsprofile beobachtet, sind diese beiden PV-Modulgruppen 10 mit großer Wahrscheinlichkeit nah beieinander positioniert. Werden dagegen unterschiedliche Lichtabsorptionsprofile beobachtet, deutet dieses auf einen größeren Abstand der beiden PV-Modulgruppen 10 voneinander hin. Der Vergleich der Lichtabsorptionsprofile kann alternativ oder in Ergänzung zu der zuvor beschriebenen Bestimmung der zeitlichen Verschiebung von Verschattungszeitpunkten zur Bestimmung eines Anlagenplans eingesetzt werden.

Neben den beiden beschriebenen Verfahren können weitere Verfahren, zum Beispiel basierend auf genetischen Algorithmen oder neuronalen Netzen oder basierend auf Wahrscheinlichkeitskarten eingesetzt werden. Zusätzlich ist in diesen Fällen jeweils eine iterative Vorgehensweise möglich, um Unsicherheiten in der Positionsbestimmung schrittweise zu verkleinern.

In weiteren Ausgestaltungen können die ermittelten Messwerte und/oder zu bestimmten Zeiten ermittelte Wolkenzugrichtungen und -geschwindigkeiten auch gespeichert werden, um für nachfolgende Iterationen oder erneute Auswertungen zur Verfügung zu stehen. In weiteren Ausgestaltungen ist denkbar, bekannte Positionen einzelner PV-Modulgruppen 10 vorzugeben. Die Messwerte solcher Gruppen 10 können dann vorteilhaft zur Bestimmung von Wolkenzugrichtungen und -geschwindigkeiten genutzt werden. Der gleiche Effekt lässt sich auch mit Beleuchtungssensoren erzielen, die an bekannten Positionen innerhalb der PV-Anlage 1 angeordnet sind und die Messwerte zur Einstrahlungsintensität bereitstellen, die auf gleiche Art und Weise von der Einrichtung 3 verarbeitet werden, wie die Messwerte von PV- Modulgruppen 10, deren Position bekannt ist. Vorteilhafterweise werden mindestens drei solcher Beleuchtungssensoren im Randbereich der PV-Anlage 1 eingesetzt, die ein möglichst in alle vorkommenden Wolkenzugrichtungen eine ausreichende Ausdehnung aufweisendes ( z. B. gleichschenkliges oder gleichseitiges) Dreieck aufspannen.

In weiteren Ausgestaltungen kann vorgesehen sein, bekannte Positionen von Wechselrichtern zur Bestimmung der Anlagentopologie mit hinzuzuziehen. Wechselrichter werden üblicherweise so innerhalb einer PV-Anlage angeordnet, dass insgesamt möglichst geringe ohmsche Energieverluste in Gleichstromleitungen, mit denen die PV-Modulgruppen mit den Wechselrichtern verbunden sind, auftreten. Dieses Designgrundprinzip kann umgekehrt genutzt werden, um im Rahmen des erfindungsgemäßen Verfahrens eine Bewertung aufgefundener (möglicher) Anlagentopologien vorzunehmen. Dieses kann zum Beispiel einen Iterationsprozess beim Auffinden der tatsächlichen Anlagentopologie beschleunigen.

Falls die Positionen der Wechselrichter nicht aufgrund von Installations- oder Wartungsplänen bekannt sind, können sie auch durch automatische Verfahren bestimmt werden. Beispielsweise ist es möglich, die Position von Wechselrichtern zueinander anhand von Funksignalen zu bestimmen, die die Wechselrichter zum Datenaustausch untereinander und/oder mit einer oder mehreren zentralen Datenverarbeitungseinrichtungen austauschen. Derartige Verfahren zur Ermittlung von Teilnehmern eines Funknetzwerkes sind grundsätzlich, z.B. aus dem Mobilfunkbereich, bekannt.

In einer weiteren Ausgestaltung kann statt nur der Position der PV-Modulgruppen 10 zusätzlich deren Ausdehnung bestimmt werden. Die Ausdehnung der Modulgruppen 10 hat direkten Einfluss auf die Breite eines Abfalls bzw. Anstiegs der erfassten elektrischen Kenngröße, so dass aus einer Analyse dieser Übergangsbreiten Aussagen über die laterale Ausdehnung der Modulgruppen in der jeweiligen Wolkenzugrichtung ermöglicht wird. Werden mehrere Zugrichtungen berücksichtigt, erhält man auf diese Weise Informationen über die Form und Flächenausdehnung der betrachteten Modulgruppen10.

In einer Ausführungsform dieser Analyse werden die unterschiedlichen Positionen, die aus verschiedenen Messungen hervorgehen nicht mehr unbedingt als Störung bzw. Fehler betrachtet, sondern als Effekt der nicht punktförmigen Ausdehnung der PV-Modulgruppen 10. Auf diese Weise erhält man die ebenfalls die Form der PV-Modulgruppen 10.

Es versteht sich, dass die beschriebenen Verfahren auch auf Teile einer PV-Anlage angewendet werden kann und nicht zwingend auf die ganze Anlage anzuwenden ist.

### Bezugszeichenliste

- 1: PV-Anlage
- 2: Rand
- 3: Einrichtung zur Bestimmung der räumlichen Anordnung
- 4: Signalleitung
- 5: Wetterstation
- 6: Kamera
- 7: Datenbank

- 10: PV-Modulgruppe
- 11: PV-Modul

- 20: Mehrkreiswechselrichter
- 21: Einzelwechselrichter

## Patentansprüche

1. Verfahren zur Bestimmung einer räumlichen Anordnung von Photovoltaikmodulgruppen (10) einer Photovoltaikanlage (1) mit den folgenden Schritten:
- Messen einer Folge von Messwerten einer bestrahlungsabhängigen elektrischen Kenngröße von unterschiedlichen Photovoltaikmodulgruppen (10), während die Photovoltaikanlage (1) einer Lichteinstrahlung mit einer zeitlich und räumlich variierenden Einstrahlungsintensität ausgesetzt wird; und
- Bestimmen der relativen räumlichen Anordnung der unterschiedlichen Photovoltaikmodulgruppen (10) zueinander durch Vergleichen von unterschiedlichen Photovoltaikmodulgruppen (10) zugeordneten Folgen von Messwerten.

2. Verfahren nach Anspruch 1, wobei das Vergleichen ein Ermitteln einer Ähnlichkeit eines Zeitverlaufs der Folgen von Messwerten umfasst.

3. Verfahren nach Anspruch 1 oder 2, wobei das Vergleichen ein Ermitteln von Zeitverschiebungen zwischen den Folgen von Messwerten umfasst.

4. Verfahren nach Anspruch 3, wobei das Ermitteln von Zeitverschiebungen ein Bestimmen von Verschattungszeitpunkten der unterschiedlichen Photovoltaikmodulgruppe (10) umfasst, und wobei die Zeitverschiebungen als Differenz der Verschattungszeitpunkte unterschiedlicher Photovoltaikmodulgruppen (10) bestimmt wird.

5. Verfahren nach Anspruch 4, wobei die Verschattungszeitpunkte mittels eines Schwellwertkriteriums für die elektrische Kenngröße oder für eine zeitliche Änderung der Kenngröße bestimmt wird.

6. Verfahren nach Anspruch 3, wobei das Ermitteln von Zeitverschiebungen ein Vergleich der Folgen von Messwerten unterschiedlicher Photovoltaikmodulgruppen (10) umfasst, wobei die ermittelte Zeitverschiebung einem relativen Zeitversatz der Folgen zueinander entspricht, bei der die Folgen von Messwerten minimale Abweichung voneinander aufweisen.

7. Verfahren nach Anspruch 3, wobei das Ermitteln von Zeitverschiebungen einen Vergleich der Folgen von Messwerten unterschiedlicher Photovoltaikmodulgruppen (10) mit einem Modell von Folgen von Messwerten basierend auf einer angenommenen räumlichen Anordnung der Photovoltaikmodulgruppen (10) umfasst.

8. Verfahren nach einem der Ansprüche 1 bis 7, bei dem die bestrahlungsabhängige elektrische Kenngröße ein von der Photovoltaikmodulgruppe (10) gelieferter Strom (I), eine gelieferte Leistung (P) oder eine bereitgestellte Spannung ist.

9. Verfahren nach einem der Ansprüche 1 bis 8, bei dem die Messung der bestrahlungsabhängigen elektrischen Kenngröße der Photovoltaikmodulgruppe (10) zumindest für einen Teil der Photovoltaikmodulgruppe (10) innerhalb eines Wechselrichters (20, 21), mit dem die entsprechenden Photovoltaikmodulgruppe (10) verbunden sind, ausgeführt wird.

10. Verfahren nach einem der Ansprüche 1 bis 9, bei dem die Photovoltaikmodulgruppe (10) ein Photovoltaikmodul (11) oder eine Anordnung mehrerer verschalteter Photovoltaikmodule (11) ist.

11. Verfahren nach einem der Ansprüche 1 bis 10, bei dem die zeitlich und räumlich variierende Einstrahlungsintensität durch eine manuell induzierte Verschattung hervorgerufen wird.

12. Verfahren nach einem der Ansprüche 1 bis 10, bei dem die zeitlich und räumlich variierende Einstrahlungsintensität durch eine Verschattung durch Wolken hervorgerufen wird.

13. Verfahren nach einem der Ansprüche 1 bis 10, bei dem die zeitlich und räumlich variierende Einstrahlungsintensität durch eine Teilverschattung durch ein feststehendes Element hervorgerufen wird.

14. Verfahren nach Anspruch 13, bei dem das feststehende Element ein Teil der Photovoltaikanlage (1), insbesondere eine der Photovoltaikmodulgruppen (10), ist.

15. Verfahren nach einem der Ansprüche 1 bis 14, wobei eine oder mehrere der Photovoltaikmodulgruppen (10) eine vorbekannte Position innerhalb der Photovoltaikanlage (1) haben.

16. Verfahren nach einem der Ansprüche 1 bis 15, bei dem zur Bestimmung der räumlichen Anordnung der Photovoltaikmodulgruppen (10) Wetterdaten, insbesondere Windgeschwindigkeit und Windrichtung, berücksichtigt werden.

17. Verfahren nach Anspruch 16, wobei die Wetterdaten aus Bilddaten einer Kamera (6) ermittelt werden.

18. Verfahren nach einem der Ansprüche 1 bis 17, wobei aus der Folge von Messwerten einer Photovoltaikmodulgruppe (10) deren räumliche Ausdehnung bestimmt wird.

19. Verfahren nach einem der Ansprüche 1 bis 18, bei dem zur Bestimmung der räumlichen Anordnung der Photovoltaikmodulgruppen (10) zusätzlich die räumliche Anordnung von Wechselrichtern (20, 21) berücksichtigt wird.

20. Verfahren nach Anspruch 19, bei dem die räumliche Anordnung der Wechselrichter (20, 21) anhand von Funksignalen bestimmt wird, die die Wechselrichter (20, 21) zum Datenaustausch untereinander und/oder mit einer oder mehreren zentralen Datenverarbeitungseinrichtungen austauschen.

21. Photovoltaikanlage mit einer Einrichtung (3) zur Bestimmung einer räumlichen Anordnung von Photovoltaikmodulgruppen (10), die zur Durchführung eines Verfahrens gemäß einem der Ansprüche 1 bis 20 eingerichtet ist.
